# EUROPÄISCHE PATENTANMELDUNG

(11) **EP 4 718 668 A1**
(43) Veröffentlichungstag der Anmeldung: **01.04.2026**
(21) Anmeldenummer: 24202882.7
(22) Anmeldetag: 26.09.2024
(51) Int. Cl.: H02J 7/00, G01R 31/389

(54) **VERFAHREN ZUM STEUERN UND REGELN EINES BATTERIEPACKS EINER ELEKTRISCHEN HANDWERKZEUGMASCHINE**

(71) Anmelder: Hilti Aktiengesellschaft, 9494 Schaan (LI)
(72) Erfinder: Stanger, Robert, 87600 Kaufbeuren (DE)
(74) Vertreter: Hilti Aktiengesellschaft Corporate Intellectual Property

(57) **Zusammenfassung**

Verfahren zum Steuern und Regeln wenigstens einer Lithiumionen-Batteriezelle als Bestandteil eines Batteriepacks, insbesondere Versorgung einer elektrischen Werkzeugmaschine mit elektrischer Energie.

Das Verfahren enthält die Verfahrensschritte:
- Verbinden der wenigstens einen Lithiumionen-Batteriezelle mit einer Ladevorrichtung;
- Bestimmung eines ersten Innenwiderstandwertes der wenigstens einen Lithiumionen-Batteriezelle vor Beginn eines Ladevorgangs;
- Einstellen eines ersten Ladestroms an der Ladevorrichtung in Abhängigkeit des ersten Innenwiderstandwertes;
- Verbinden der wenigstens einen Lithiumionen-Batteriezelle mit einer Werkzeugmaschine;
- Bestimmung eines zweiten Innenwiderstandwertes der wenigstens einen Lithiumionen-Batteriezelle vor Beginn eines Entladevorgangs; und
- Einstellen eines Entladestroms in Abhängigkeit des zweiten Innenwiderstandwertes, wenn die wenigstens eine Lithiumionen-Batteriezelle zur Energieversorgung mit der Werkzeugmaschine verbunden ist.

## Beschreibung

Die vorliegende Erfindung betrifft ein Verfahren zum Steuern und Regeln wenigstens einer Lithiumionen-Batteriezelle als Bestandteil eines Batteriepacks, insbesondere Versorgung einer elektrischen Werkzeugmaschine mit elektrischer Energie.

Elektrische Werkzeugmaschinen werden oftmals durch Batteriepacks mit einer Anzahl an Lithiumionen-Batteriezellen mit elektrischer Energie versorgt. Wenn diese Batteriepacks mit einer Ladevorrichtung verbunden werden, können die Batteriezellen mit elektrischer Energie befüllt werden.

Lithiumionen-Batteriezelle als Bestandteil eines Batteriepacks unterliegen einem gewissen Alterungsprozess, wodurch sich die Leistungsaufnahme und Leistungsabgabe der Batteriezellen reduziert sowie die Lebensdauer der Batteriezellen verkürzt wird. Das Laden und Entladen der Batteriezellen mit elektrischer Energie wird hierdurch verschlechtert.

Es ist Aufgabe der vorliegenden Erfindung das vorstehend beschrieben Problem zu lösen.

Die Aufgabe wird durch den Gegenstand des Anspruchs 1 gelöst.

Weitere vorteilhafte Ausführungsformen des erfindungsgemäßen Gegenstands sind in den entsprechenden abhängigen Patentansprüchen enthalten.

Die Aufgabe wird dabei insbesondere gelöst durch ein Verfahren zum Steuern und Regeln wenigstens einer Lithiumionen-Batteriezelle als Bestandteil eines Batteriepacks, insbesondere Versorgung einer elektrischen Werkzeugmaschine mit elektrischer Energie.

Erfindungsgemäß sind die folgenden Verfahrensschritte enthalten:
- Verbinden der wenigstens einen Lithiumionen-Batteriezelle mit einer Ladevorrichtung;
- Bestimmung eines ersten Innenwiderstandwertes der wenigstens einen Lithiumionen-Batteriezelle vor Beginn eines Ladevorgangs;
- Einstellen eines ersten Ladestroms an der Ladevorrichtung in Abhängigkeit des ersten Innenwiderstandwertes;
- Verbinden der wenigstens einen Lithiumionen-Batteriezelle mit einer Werkzeugmaschine;
- Bestimmung eines zweiten Innenwiderstandwertes der wenigstens einen Lithiumionen-Batteriezelle vor Beginn eines Entladevorgangs; und
- Einstellen eines Entladestroms in Abhängigkeit des zweiten Innenwiderstandwertes, wenn die wenigstens eine Lithiumionen-Batteriezelle zur Energieversorgung mit der Werkzeugmaschine verbunden ist.

Das Verfahren zum Steuern und Regeln enthält dabei im Wesentlichen, aber nicht ausschließlich das Laden von Batteriezellen mit elektrischer Energie sowie das Entladen von elektrischer Energie aus den Batteriezellen.

Das Einstellen eines ersten Ladestroms an einer Ladevorrichtung bedeutet, dass der Stromstärkewert zum Laden einer Batteriezelle an einer Ladevorrichtung in Abhängigkeit des ersten Innenwiderstandwertes festgelegt wird. Die entsprechenden Innenwiderstandswerte können dabei von einer Lookup-Tabelle entnommen werden. Die Lookup-Tabelle kann in einer Speichereinheit des Batteriepacks gespeichert sein.

Gemäß einer vorteilhaften Ausführungsform können die folgenden Verfahrensschritte enthalten sein
- Blockieren des Ladevorgangs wenn der Innenwiderstandwert einem ersten Schwellwert entspricht; und/oder
- Blockieren des Enladevorgangs wenn der Innenwiderstandwert einem zweiten Schwellwert entspricht, wobei der zweite Schwellwert größer ist der erste Schwellwert.

Entsprechend einer weiteren vorteilhaften Ausführungsform kann es möglich sein, dass der Lade- und Entladestrom ausschließlich in diskreten Stufen eingestellt wird. Es hat sich als vorteilhaft herausgestellt, wenn wenigstens drei, vorzugsweise vier diskrete und voneinander verschiedene Ladeströme vorgesehen sind. In einer weiteren besonders bevorzugten Ausgestaltung wird der am Ende eines jeweiligen Ladevorgangs bestimmte Innenwiderstand abgespeichert.

Gemäß einer weiteren vorteilhaften Ausführungsform kann es möglich sein, dass ein vor Beginn eines jeweiligen Lade- und Entladevorgangs bestimmter Innenwiderstandwert in einer Speichervorrichtung des Batteriepacks abgespeichert wird.

Entsprechend einer weiteren vorteilhaften Ausführungsform kann es möglich sein, dass ein am Ende eines jeweiligen Lade- und Entladevorgangs bestimmter Innenwiderstandwert in einer Speichervorrichtung des Batteriepacks abgespeichert wird.

Gemäß einer weiteren vorteilhaften Ausführungsform kann es möglich sein, dass der Batteriepack eine Mehrzahl von Lithiumionen-Batteriezellen aufweist, wobei der zur Verfügung gestellte Lade- und/oder Entladestrom auf Basis eines gemittelten Innenwiderstandwertes der Mehrzahl von Lithiumionen-Batteriezellen eingestellt wird. Es hat sich ebenfalls als vorteilhaft herausgestellt, wenn eine Leerlaufspannung (Gleichspannung) des Batteriepack weniger als 60 Volt beträgt und vorzugsweise 12 Volt, 18 Volt, 22 Volt oder 36 Volt beträgt.

Entsprechend einer weiteren vorteilhaften Ausführungsform kann es möglich sein, dass ein Innenwiderstandwert (DCR) der wenigstens einen Lithiumionen-Batteriezelle mit einem Temperatur-Zellzustand der wenigstens einen Lithiumionen-Batteriezelle gewichtet wird. So kann der Innenwiderstand beispielsweise mit einem Kehrwert der Zelltemperatur (oder einem Vielfachen des Kehrwerts) multipliziert werden. Der Kehrwert kann diskretisiert sein. Es ist denkbar den Ladestrom mittels einer Lookup-Tabelle vorzugeben. In einer anderen besonders bevorzugten Ausgestaltung des Verfahrens wird ein Temperatur-Zellzustand der Lithiumionen-Batteriezelle lediglich für eine Notabschaltung des Ladevorgangs verwendet.

Gemäß einer weiteren vorteilhaften Ausführungsform kann es möglich sein, dass ein Temperatur-Zellzustand der wenigstens einen Lithiumionen-Batteriezelle lediglich für eine Notabschaltung des Lade- und/oder Entladevorgangs verwendet wird.

Die Erfindung schließt die Erkenntnis ein, dass ein temperaturbasiertes Laden eines Lithiumionen-Batteriepacks einer elektrischen Werkzeugmaschine nur ungenaue, nicht auf den Gesundheitszustand (= State of Health (SoH)) der Lithiumionen-Batteriezelle abgestimmte Ladeströme ermöglicht. Dadurch sind die Ladezeiten bei Lithiumionen-Batteriezellen mit gutem Gesundheitszustand (SoH) länger als nötig. Bei Lithiumionen-Batteriezellen mit schlechtem Gesundheitszustand (SoH) schreitet die Alterung schneller voran, da die Ladeströme ggf. zu hoch sind und die Lithiumionen-Batteriezellen möglicherweise schädigen.

Es wurde weiterhin erkannt, dass der Gesundheitszustand (SoH) der Lithiumionen-Batteriezellen als direkt proportional zum Widerstand (= Direct Current Resistance (DCR)) der Lithiumionen-Batteriezelle angenommen werden kann. Somit ist es möglich, den Ladestrom nach erfolgter Bestimmung des Widerstands an den jeweiligen SoH anzupassen. Somit kann bei einer Lithiumionen-Batteriezelle mit gutem Gesundheitszustand (dies entspricht einem vergleichsweise geringem Innenwiderstand DCR) einerseits der Ladeström erhöht werden, wodurch die Ladezeiten verkürzt werden. Andererseits kann bei einer gealterten Lithiumionen-Batteriezelle (dies entspricht einem vergleichsweise hohen Innenwiderstand DCR) der Ladestrom reduziert werden, wodurch eine Alterung der Lithiumionen-Batteriezelle verlangsamt und somit die Lebensdauer erhöht wird.

In einer besonders bevorzugten Ausgestaltung des Verfahrens zum Steuern und Regeln wenigstens einer Lithiumionen-Batteriezelle wird der Innenwiderstand einer Lithiumionen-Batteriezelle gemessen und/oder bestimmt. Dazu kann eine Leerlaufspannung der Lithiumionen-Batteriezelle ohne Belastung und/oder eine Arbeitsspannung der mit einem vorgegebenen Widerstand belasteten Lithiumionen-Batteriezelle gemessen werden.

Weitere Vorteile ergeben sich aus der folgenden Figurenbeschreibung.

In den Figuren sind besonders bevorzugte Ausführungsbeispiel der vorliegenden Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In den Figuren sind gleiche und gleichartige Komponenten mit gleichen Bezugszeichen beziffert.

Es zeigen
- Figur 1: ein bevorzugtes Ausführungsbeispiel eines Batteriezellen-Ladeverfahren;
- Figur 2: ein bevorzugtes Ausführungsbeispiel eines Batteriezellen-Ladesystems; und
- Figur 3: ein bevorzugtes Ausführungsbeispiel eines Batteriezellen-Ladeverfahren.

### Ausführungsbeispiele:

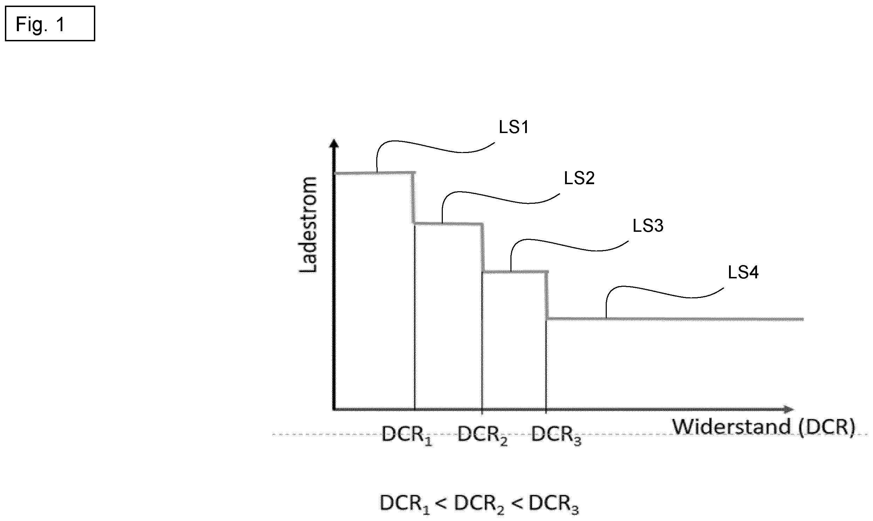

Ein bevorzugtes Ausführungsbeispiel eines Batteriezellen-Ladeverfahrens soll mit Bezug auf das in Figur 1 gezeigte schematisierte Diagrammform erläutert werden.

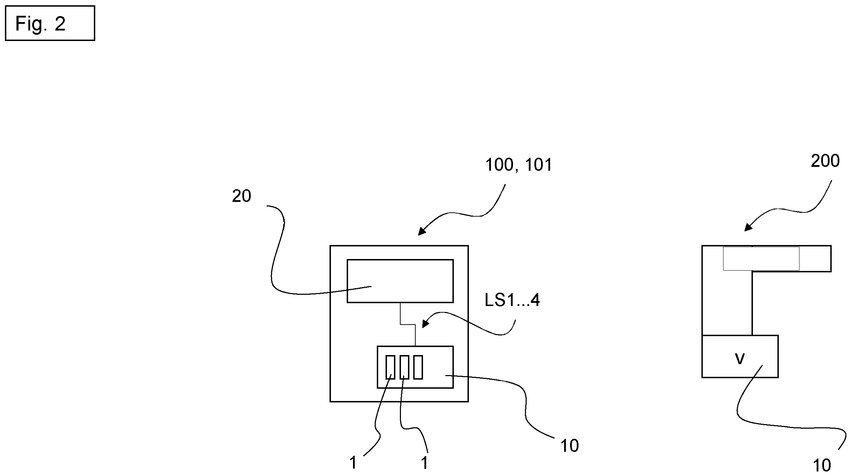

Das Batteriezellen-Ladeverfahren kommt vorzugsweise zum Laden einer Lithiumionen-Batteriezelle eines Batteriepacks 10 (vgl. Figur 2) einer elektrischen Handwerkzeugmaschine zum Einsatz. Im Diagramm in Fig. 1 ist der an die Lithiumionen-Batteriezelle gelieferte Ladestrom (Ordinate) über dem momentanen Innenwiderstand der Lithiumionen-Batteriezelle DCR (Abszisse) aufgetragen.

Im Rahmen des erfindungsgemäßen Verfahrens ist vorgesehen, dass der der Lithiumionen-Batteriezelle zur Verfügung gestellte Ladestrom auf Basis des Innenwiderstands DCR (der den Gesundheitszustand SoH repräsentiert) eingestellt wird. Im Rahmen des Verfahrens wird der Innenwiderstand DCR der Lithiumionen-Batteriezelle gemessen. Dies kann kontinuierlich erfolgen oder am Beginn eines jeweiligen Ladevorgangs. Alternativ oder zusätzlich kann der Innenwiderstand DCR aus einem Speicher ausgelesen werden. Vorteilhaft ist vorgesehen, dass der am Ende eines jeweiligen Ladevorgangs bestimmte Innenwiderstand abgespeichert wird.

Im gesunden Neuzustand weist die Lithiumionen-Batteriezelle 1 (vgl. Figur 2) beispielhaft einen Innenwiderstand DCR auf, der unterhalb einer ersten Innenwiderstandsschwelle DCR1 liegt. Die erste Innenwiderstandsschwelle DCR1 beträgt beispielhaft 0,1 Ohm. Die Lithiumionen-Batteriezelle wird mit einem ersten Ladestrom LS1 aufgeladen. Der ersten Ladestrom LS1 beträgt beispielhaft konstant 4 Ampere.

Nach mehreren Ladevorgängen kann die Lithiumionen-Batteriezelle beispielhaft einen Innenwiderstand DCR aufweisen, der zwischen der ersten Innenwiderstandsschwelle DCR1 und einer zweiten Innenwiderstandsschwelle DCR2 liegt. Die zweite Innenwiderstandsschwelle DCR2 beträgt beispielhaft 0,2 Ohm. Die Lithiumionen-Batteriezelle ist somit gealtert. Die Lithiumionen-Batteriezelle wird nun mit einem zweiten Ladestrom LS2 aufgeladen. Der zweite Ladestrom LS2 ist geringer als der erste Ladestrom LS1 und beträgt beispielhaft konstant 3 Ampere.

Nach weiteren Ladevorgängen kann die Lithiumionen-Batteriezelle beispielhaft einen Innenwiderstand DCR aufweisen, der zwischen der zweiten Innenwiderstandsschwelle DCR2 und einer dritten Innenwiderstandsschwelle DCR3 liegt. Die dritte Innenwiderstandsschwelle DCR3 beträgt beispielhaft 0,3 Ohm. Die Lithiumionen-Batteriezelle wird nun mit einem dritten Ladestrom LS3 aufgeladen. Der dritte Ladestrom LS3 ist geringer als der zweite Ladestrom LS2 und beträgt beispielhaft konstant 2 Ampere.

Nahe ihres Lebenszeitendes kann die Lithiumionen-Batteriezelle beispielhaft einen Innenwiderstand DCR aufweisen, der über der dritten Innenwiderstandsschwelle DCR3 liegt. In diesem Fall wird die Lithiumionen-Batteriezelle von nun an mit einem vierten Ladestrom LS4 aufgeladen, der beispielhaft konstant 1 Ampere beträgt. Das eben beschriebene verdeutlicht, dass beim Überschreiten einer vorbestimmten Innenwiderstandsschwelle jeweils niedriger Ladestrom in diskreten Stufen (beispielhaft von jeweils 1 Ampere) eingestellt wird.

Es ist grundsätzlich denkbar, dass aufgrund von Selbstorganisationsprozessen innerhalb der Lithiumionen-Batteriezelle deren Innenwiderstand DCR steigt. Für diesen Fall kann vorgesehen sein, dass beim Unterschreiten einer vorbestimmten Innenwiderstandsschwelle ein höherer Ladestrom eingestellt wird.

Figur 2 zeigt - in stark schematisierter Form - ein bevorzugtes Ausführungsbeispiel eines Batteriezellen-Ladesystems 100. Das Batteriezellen-Ladesystem 100 dient zum Laden einer Lithiumionen-Batteriezelle 1 eines Batteriepacks 10 einer elektrischen Handwerkzeugmaschine 200. Das Batteriezellen-Ladesystem 100 weist einen Ladecontroller 20 auf, der eingerichtet ist, ein der Lithiumionen-Batteriezelle 1 zur Verfügung gestellten Ladestrom LS1...4 auf Basis eines die Lithiumionen-Batteriezelle 1 charakterisierenden Zellzustands, nämlich eines Innenwiderstands DCR der Lithiumionen-Batteriezelle 1, einzustellen. Dazu ist der Ladecontroller 20 eingerichtet, dass mit Bezug auf Figur 1 beschriebene Batteriezellen-Ladeverfahren auszuführen.

Der Ladecontroller 20 ist beispielhaft von einer Ladestation 101, die vorliegend das Batteriezellen-Ladesystem 100 bildet, umfasst.

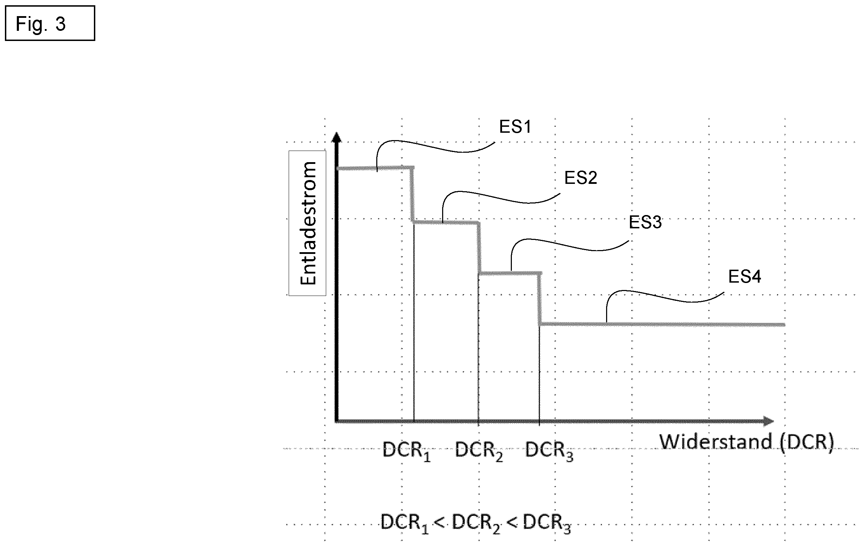

In Figur 3 ist mit Hilfe einer schematisierten Diagrammform ein bevorzugtes Ausführungsbeispiel eines Batteriezellen-Entladeverfahrens dargestellt.

Das Batteriezellen-Entladeverfahren kommt vorzugsweise zum Entladen einer Lithiumionen-Batteriezelle eines Batteriepacks 10 (vgl. Figur 2) zum Einsatz. Das Entladen einer Lithiumionen-Batteriezelle eines Batteriepacks 10 findet während der Versorgung einer elektrischen Handwerkzeugmaschine mit elektrischer Energie statt.

Ähnlich zu dem Diagramm in Figur 1 ist in Figur 3 der jeweilige Entladestrom (Ordinate) im Verhältnis zu dem momentanen Innenwiderstand der Lithiumionen-Batteriezelle DCR (Abszisse) dargestellt.

Im Rahmen des erfindungsgemäßen Verfahrens ist vorgesehen, dass der von der Lithiumionen-Batteriezelle zur Verfügung stehende Entladestrom auf Basis des Innenwiderstands DCR (der den Gesundheitszustand SoH repräsentiert) eingestellt wird. Im Rahmen des Verfahrens wird der Innenwiderstand DCR der Lithiumionen-Batteriezelle gemessen. Dies kann kontinuierlich erfolgen oder am Beginn eines jeweiligen Entladevorgangs. Alternativ oder zusätzlich kann der Innenwiderstand DCR aus einem Speicher ausgelesen werden. Vorteilhaft ist vorgesehen, dass der am Ende eines jeweiligen Entladevorgangs bestimmte Innenwiderstand abgespeichert wird.

Im gesunden Neuzustand weist die Lithiumionen-Batteriezelle 1 (vgl. Figur 2) beispielhaft einen Innenwiderstand DCR auf, der unterhalb einer ersten Innenwiderstandsschwelle DCR1 liegt. Die erste Innenwiderstandsschwelle DCR1 beträgt beispielhaft 0,1 Ohm. Die Lithiumionen-Batteriezelle wird mit einem ersten Entladestrom ES1 aufgeladen. Der ersten Entladestrom ES1 beträgt beispielhaft konstant 4 Ampere.

Nach mehreren Entladevorgängen kann die Lithiumionen-Batteriezelle beispielhaft einen Innenwiderstand DCR aufweisen, der zwischen der ersten Innenwiderstandsschwelle DCR1 und einer zweiten Innenwiderstandsschwelle DCR2 liegt. Die zweite Innenwiderstandsschwelle DCR2 beträgt beispielhaft 0,2 Ohm. Die Lithiumionen-Batteriezelle ist somit gealtert. Die Lithiumionen-Batteriezelle wird nun mit einem zweiten Entladestrom ES2 aufgeladen. Der zweite Entladestrom ES2 ist geringer als der erste Entladestrom ES1 und beträgt beispielhaft konstant 3 Ampere.

Nach weiteren Entladevorgängen kann die Lithiumionen-Batteriezelle beispielhaft einen Innenwiderstand DCR aufweisen, der zwischen der zweiten Innenwiderstandsschwelle DCR2 und einer dritten Innenwiderstandsschwelle DCR3 liegt. Die dritte Innenwiderstandsschwelle DCR3 beträgt beispielhaft 0,3 Ohm. Die Lithiumionen-Batteriezelle wird nun mit einem dritten Entladestrom ES3 aufgeladen. Der dritte Entladestrom ES3 ist geringer als der zweite Entladestrom ES2 und beträgt beispielhaft konstant 2 Ampere.

Nahe ihres Lebenszeitendes kann die Lithiumionen-Batteriezelle beispielhaft einen Innenwiderstand DCR aufweisen, der über der dritten Innenwiderstandsschwelle DCR3 liegt. In diesem Fall wird die Lithiumionen-Batteriezelle von nun an mit einem vierten Entladestrom ES4 aufgeladen, der beispielhaft konstant 1 Ampere beträgt. Das eben beschriebene verdeutlicht, dass beim Überschreiten einer vorbestimmten Innenwiderstandsschwelle jeweils niedriger Entladestrom in diskreten Stufen (beispielhaft von jeweils 1 Ampere) eingestellt wird.

Es ist grundsätzlich denkbar, dass aufgrund von Selbstorganisationsprozessen innerhalb der Lithiumionen-Batteriezelle deren Innenwiderstand DCR steigt. Für diesen Fall kann vorgesehen sein, dass beim Unterschreiten einer vorbestimmten Innenwiderstandsschwelle ein höherer Entladestrom eingestellt wird.

### Bezugszeichenliste

- 1: Lithiumionen-Batteriezelle
- 10: Batteriepack
- 20: Controller
- 100: Batteriezellen-Ladesystem
- 101: Ladestation
- 200: Elektrische Handwerkzeugmaschine

- SoH: Gesundheitszustand
- DCR: Innenwiderstand
- DCR1: erste Innenwiderstandsschwelle
- DCR2: zweite Innenwiderstandsschwelle
- DCR3: dritte Innenwiderstandsschwelle
- LS1: erster Ladestrom
- LS2: zweiter Ladestrom
- LS3: dritter Ladestrom
- LS4: vierter Ladestrom

- ES1: erster Entladestrom
- ES2: zweiter Entladestrom
- ES3: dritter Entladestrom
- ES4: vierter Entladestrom

## Patentansprüche

1. Verfahren zum Steuern und Regeln wenigstens einer Lithiumionen-Batteriezelle als Bestandteil eines Batteriepacks, insbesondere Versorgung einer elektrischen Werkzeugmaschine mit elektrischer Energie,
gekennzeichnet mit den Verfahrensschritten:
- Verbinden der wenigstens einen Lithiumionen-Batteriezelle mit einer Ladevorrichtung;
- Bestimmung eines ersten Innenwiderstandwertes der wenigstens einen Lithiumionen-Batteriezelle vor Beginn eines Ladevorgangs;
- Einstellen eines ersten Ladestroms an der Ladevorrichtung in Abhängigkeit des ersten Innenwiderstandwertes;
- Verbinden der wenigstens einen Lithiumionen-Batteriezelle mit einer Werkzeugmaschine;
- Bestimmung eines zweiten Innenwiderstandwertes der wenigstens einen Lithiumionen-Batteriezelle vor Beginn eines Entladevorgangs; und
- Einstellen eines Entladestroms in Abhängigkeit des zweiten Innenwiderstandwertes, wenn die wenigstens eine Lithiumionen-Batteriezelle zur Energieversorgung mit der Werkzeugmaschine verbunden ist.

2. Verfahren nach Anspruch 1,
**gekennzeichnet durch** die Verfahrensschritte
- Blockieren des Ladevorgangs wenn der Innenwiderstandwert einem ersten Schwellwert entspricht; und/oder
- Blockieren des Enladevorgangs wenn der Innenwiderstandwert einem zweiten Schwellwert entspricht, wobei der zweite Schwellwert größer ist der erste Schwellwert.

3. Verfahren nach Anspruch 1 oder 2,
**dadurch gekennzeichnet, dass** der Lade- und Entladestrom ausschließlich in diskreten Stufen eingestellt wird.

4. Verfahren nach wenigstens einem der vorangehenden Ansprüche,
**dadurch gekennzeichnet, dass** ein vor Beginn eines jeweiligen Lade- und Entladevorgangs bestimmter Innenwiderstandwert in einer Speichervorrichtung des Batteriepacks abgespeichert wird.

5. Verfahren nach wenigstens einem der vorangehenden Ansprüche,
**dadurch gekennzeichnet, dass** ein am Ende eines jeweiligen Lade- und Entladevorgangs bestimmter Innenwiderstandwert in einer Speichervorrichtung des Batteriepacks abgespeichert wird.

6. Verfahren nach wenigstens einem der vorangehenden Ansprüche,
**dadurch gekennzeichnet, dass** der Batteriepack eine Mehrzahl von Lithiumionen-Batteriezellen aufweist, wobei der zur Verfügung gestellte Lade- und/oder Entladestrom auf Basis eines gemittelten Innenwiderstandwertes der Mehrzahl von Lithiumionen-Batteriezellen eingestellt wird.

7. Verfahren nach wenigstens einem der vorangehenden Ansprüche,
**dadurch gekennzeichnet, dass** ein Innenwiderstandwert (DCR) der wenigstens einen Lithiumionen-Batteriezelle mit einem Temperatur-Zellzustand der wenigstens einen Lithiumionen-Batteriezelle gewichtet wird.

8. Verfahren nach wenigstens einem der vorangehenden Ansprüche,
**dadurch gekennzeichnet, dass** ein Temperatur-Zellzustand der wenigstens einen Lithiumionen-Batteriezelle lediglich für eine Notabschaltung des Lade- und/oder Entladevorgangs verwendet wird.
